# EUROPÄISCHE PATENTSCHRIFT

(11) **EP 1 687 855 B1**
(45) Veröffentlichungstag und Bekanntmachung des Hinweises auf die Patenterteilung: **16.04.2008**
(21) Anmeldenummer: 04802829.4
(22) Anmeldetag: 25.11.2004
(51) Int. Cl.: H01L 45/00, H01L 27/24, G11C 11/34

(54) **INTEGRIERTER HALBLEITERSPEICHER UND VERFAHREN ZUM HERSTELLEN EINES INTEGRIERTEN HALBLEITERSPEICHERS**
INTEGRATED SEMICONDUCTOR MEMORY AND METHOD FOR PRODUCING AN INTEGRATED SEMICONDUCTOR MEMORY
MEMOIRE A SEMI-CONDUCTEURS INTEGRES ET PROCEDE POUR PRODUIRE UNE MEMOIRE A SEMI-CONDUCTEURS INTEGRES

(30) Priorität: 28.11.2003 DE 10356285
(43) Veröffentlichungstag der Anmeldung: 09.08.2006
(73) Patentinhaber: Qimonda AG, 81739 München (DE)
(72) Erfinder: HAPP, Thomas, Pleasantville, NY 10570 (US); PINNOW, Cay-Uwe, 81929 München (DE); SYMANCZYK, Ralf, 81673 München (DE); UFERT, Klaus-Dieter, 85716 Unterschleissheim (DE)
(74) Vertreter: Epping - Hermann - Fischer
(86) Internationale Anmeldenummer: PCT/DE2004/002620
(87) Internationale Veröffentlichungsnummer: WO 2005/053047

(56) Entgegenhaltungen:
- EP-A- 1 355 365
- WO-A-03/079463
- WO-A-20/04017436
- DE-B1- 1 465 450

## Beschreibung

Die Erfindung betrifft einen integrierten Halbleiterspeicher sowie ein Verfahren zum Herstellen eines integrierten Halbleiterspeichers.

In der Halbleiterfertigung werden Halbleiterspeicher hergestellt, die eine Vielzahl von Speicherzellen aufweisen, die in einem Speicherzellenfeld angeordnet sind. Man unterscheidet flüchtige und nicht-flüchtige Halbleiterspeicher. Nicht-flüchtige Halbleiterspeicher, die gespeicherte Informationen auch nach Abschalten der Spannungsversorgung speichern, können als Phasenwechselspeicher ausgebildet werden. Phasenwechselspeicher besitzen ein Speichermedium, das zwei verschiedene Zustände unterschiedlich hoher elektrischer Leitfähigkeit annehmen kann und zwischen diesen beiden Zuständen einen Phasenübergang durchläuft. Die unterschiedliche Leitfähigkeit des Speichermediums kann in Phasenwechselspeichern ausgenutzt werden, um digitale Informationen zu speichern. Beispielsweise wird eine Schicht aus einem Phasenwechselmedium zwischen zwei Elektroden angeordnet, an die eine äußere Spannung angelegt wird. Anhand der Höhe des Stromflusses durch die Elektroden und das Phasenwechselmedium hindurch kann bestimmt werden, in welchem Aggregatzustand sich das Phasenwechselmedium befindet. Ferner kann mit stärkeren Strömen, die das Phasenwechselmedium auf höhere Temperaturen oberhalb der Kristallisations- bzw. Schmelztemperatur erhitzen, der Zustand des Speichermediums verändert und damit eine digitale Information überschrieben werden.

Ferner existieren weitere Konzepte für Speichermedien, die aufgrund anderer Eigenschaften, beispielsweise magnetischer Eigenschaften oder ihrer ferroelektrischen Polarisierbarkeit verschiedene Zustände annehmen können, in denen sich die jeweilige elektrische Leitfähigkeit des Speichermediums ausreichend stark unterscheidet, um zwei unterschiedliche digitale Informationen darzustellen.

In einer integrierten Halbleiterschaltung kann der Speicherzustand einer einzelnen Speicherzelle nur elektrisch verändert werden, d.h. durch einen durch das Speichermedium hindurch oder in dessen Umgebung fließenden Strom, oder durch eine Spannung, die am Speichermedium angelegt wird. Je höher der zur Änderung des Zustandes des Speichermediums und damit zum Umschreiben der digitalen Information erforderliche Strom ist, umso höher ist der Energieverbrauch des integrierten Halbleiterspeichers. Insbesondere bei Phasenwechselmedien und anderen Speichermedien, deren Zustand temperaturabhängig ist, erfordern die zum Erhitzen auf die Phasenübergangs- oder Schmelztemperaturen Ströme eine erhebliche Energiemenge.

Die zum Programmieren der Speicherzellen erforderlichen Temperaturerhöhungen sind nur durch starke Programmierströme erreichbar. Speicherbauelemente mit einem Phasenwechselmedium, das diese hohen Programmierströme benötigt, können nicht ohne weiteres gemeinsam mit anderen Bauelementen wie Auswahltransistoren in eine einzige Halbleiterschaltung integriert werden, wenn die anderen Bauelemente entsprechend der kleinstmöglichen Strukturbreite dimensioniert sein sollen. In heutigen Speicherschaltungen liegen zulässige Maximalströme von CMOS-Transistoren bei etwa 0,5 mA pro Mikrometer Kanalbreite.

Außerdem besteht das Problem, daß im Falle hoher Ströme zum Umschreiben einer digitalen Information nur sehr wenige Speicherzellen zur gleichen Zeit überschrieben werden können, ohne daß die maximal zulässige Stromdichte in Teilbereichen der Halbleiterschaltung überschritten wird. Die derzeit noch recht hohen Programmierströme beschränken daher den Grad der Parallelität des Speicherbetriebs.

WO 03/079463 A2 offenbart, in einer Speicherschicht aus einem Ionenleiter-Material ein Fremdmaterial vorzusehen, um die Stromdichte zu erhöhen. EP 1 355 365 A2 und die deutsche Auslegeschrift DE 1 465 450 offenbaren, in Phasenwechselmedien die Stromdichte lokal am Ort an einer keilförmig ausgebildeten Elektrode zu erhöhen.

Es ist die Aufgabe der vorliegenden Erfindung, einen integrierten Halbleiterspeicher bereitzustellen, der zum Umprogrammieren digitaler Informationen geringere Ströme benötigt als herkömmliche Halbleiterspeicher und in den Speicherelemente, die ein Speichermedium der eingangs genannten Art aufweisen, gemeinsam mit anderen Bauelementen wie beispielsweise Transistoren in minimaler Strukturgröße ausgeführt integriert sind und nicht mehr in separaten Teilschaltungen angeordnet oder mit größerer Strukturbreite ausgeführt werden müssen. Der Halbleiterspeicher soll außerdem eine größere Zahl digitaler Informationen gleichzeitig überschreiben können, ohne daß die maximal zulässige Stromstärke im Halbleiterspeicher überschritten wird. Ferner sollen Verfahren zur Herstellung eines solchen Halbleiterspeichers angegeben werden.

Diese Aufgabe wird erfindungsgemäß gelöst durch einen integrierten Halbleiterspeicher mit einer Speicherzelle, die eine Speicherschicht mit einem Speichermedium aufweist, das einen ersten Zustand geringerer elektrischer Leitfähigkeit und einen zweiten Zustand höherer elektrischer Leitfähigkeit annehmen kann und das zwischen dem ersten und dem zweiten Zustand einen Phasenübergang durchläuft,
- wobei der jeweilige Zustand des Speichermediums mit Hilfe eines elektrischen Stroms, der durch das Speichermedium fließt, einstellbar ist,
- wobei die Speicherschicht eine Schichtenebene aufweist, in der Bereiche aus einem anderen Material als dem Speichermedium verteilt sind und in der das Speichermedium zwischen den Bereichen aus dem anderen Material angeordnet ist,
- wobei die Bereiche aus dem anderen Material Abmessungen besitzen, die kleiner sind als eine lithographisch dimensionierbare Strukturbreite, und
- wobei das andere Material an strukturierte Bereiche einer elektrisch isolierenden Schicht angrenzt.

Die lithographisch dimensionierbare Strukturbreite kann beispielsweise die Strukturbreite einer Elektrode, die an die Speicherschicht angrenzt, oder die Strukturbreite der strukturierten Speicherschicht sein. Die Bereiche aus dem anderen Material als dem Speichermedium können räumlich vereinzelte Inseln sein oder eine zusammenhängende löchrige Schicht mit einer Vielzahl von Öffnungen bilden. Beispielsweise kann entweder die löchrige Schicht durch das Material und die vereinzelten Inseln durch das Speichermedium oder die löchrige Schicht durch das Speichermedium und die vereinzelten Inseln durch das Material gebildet werden. Ferner können die Bereiche aus dem anderen Material strukturierte Bereiche einer strukturierten elektrisch isolierenden Schicht mit umfassen oder ausschließlich aus ihnen bestehen.

Erfindungsgemäß wird ein integrierter Halbleiterspeicher bereitgestellt, der eine Lage, d.h. eine technologische Schichtenebene aufweist, in der das Speichermedium und ein Material sublithographisch so fein verteilt sind, daß in Höhe dieser Lage oder Schichtenebene nur ein gewisser Bruchteil der Grundfläche dieser Schichtenebene mit dem Speichermedium bedeckt ist. Während bei einem herkömmlichen Halbleiterspeicher das Speichermedium stets als kompakte Schicht vorhanden ist, stellt bei der erfindungsgemäß vorgesehenen Schichtenebene das Speichermedium beispielsweise eine poröse Füllung dar, dessen Poren durch vereinzelte Partikel des Materials gefüllt sind. Umgekehrt kann bei einem geringeren Volumen- und Flächenanteil des Speichermediums das Speichermedium in Form einer Vielzahl mikroskopisch kleiner Füllungen in Poren einer löchrigen, im wesentlichen zusammenhängenden Schicht aus dem Material eingebracht sein. Ebenso ist denkbar, daß das Speichermedium und das Material zu etwa gleichen Anteilen in der Schichtenebene vorgesehen sind und jeweils teilweise zu einer vernetzten Struktur zusammengewachsen sind, wobei die beiden vernetzten Strukturen aus dem Material und aus dem Speichermedium insgesamt eine kompakte Schicht darstellen.

Oberhalb und/oder unterhalb dieser Lage bzw. Schichtenebene kann das Speichermedium wie herkömmlich in kompakter Form ohne Aussparungen oder Fremdfüllungen vorgesehen sein. Die erfindungsgemäß vorgesehene Materiallage mit den eingebauten Füllungen aus Material führt bei dem eingangs genannten integrierten Halbleiterspeicher dazu, daß Ströme, die durch das Speichermedium fließen, in Höhe der Materialebene mit den eingebauten Fremdfüllungen aus einem anderen Material in viele Teilströme aufgeteilt werden, die zwischen den elektrisch isolierenden Bereichen hindurch fließen und dort jeweils eine größere Stromdichte besitzen als die mittlere Stromdichte in einem kompakten, ohne Fremdfüllungen ausgebildeten Speichermedium. Daher wird in Höhe der Schichtenebene die Stromdichte an einer Vielzahl mikroskopisch kleiner Bereiche erhöht, wodurch zugleich die Temperatur in diesen Bereichen stärker steigt als in einer kompakten Schicht aus dem Speichermedium. Dies führt dazu, daß mit vergleichsweise geringen Strömen viel größere Temperaturerhöhungen erzielbar sind als in einer Schicht aus einem kompakten Speichermedium, das keine Fremdpartikel oder Füllungen aus dem anderen Material besitzt. In Höhe der damit versehenen Materiallage wird der insgesamt durch den Querschnitt der Grundfläche einer Speicherschicht fließende Strom durch einen Bruchteil dieser Grundfläche geleitet, wodurch die Stromdichte um einen umgekehrt proportionalen Faktor steigt. Je nach Bedeckungsgrad des Flächenbereichs mit vereinzelten Inseln oder mit einer löchrigen, vernetzten Schicht aus dem Material kann die Stromdichte im verbleibenden, mit dem Speichermedium gefüllten Bereich der Grundfläche um mehrere Größenordnungen erhöht werden. Dadurch kann mit verringertem Gesamtstrom eine gleich große oder eine noch größere Temperaturerhöhung erreicht werden. Das Speichermedium wird in Höhe der mit dem Material versehenen Lage am stärksten aufgeheizt. Durch die geringeren Ströme, die bei dem erfindungsgemäßen Halbleiterspeicher zum Umprogrammieren der Speicherzellen erforderlich sind, lassen sich Speicherbauelemente mit Speichermedien wie beispielsweise Phasenwechselmedien gemeinsam mit Bauelementen wie Transistoren oder Dioden, die nur begrenzt elektrisch und thermisch belastetbar sind, gemeinsam in eine integrierte Halbleiterschaltung integrieren, ohne die übrigen Bauelemente wie etwa Auswahlransistoren künstlich größer als entsprechend der kleinstmöglichen Strukturbreite zu dimensionieren. Zudem ist es möglich, ohne die Gefahr einer Beschädigung solcher Strukturen eine größere Anzahl von Speicher zellen gleichzeitig zu programmieren. Durch das erfindungsgemäß in das Speichermedium eingebrachte Fremdmaterial wird das Volumen des Speichermediums, dessen Zustand zum Programmieren verändert werden muß, verringert, wodurch der Energieverbrauch gesenkt wird.

Erfindungsgemäss ist schliesslich vorgesehen, daß das andere Material an strukturierte Bereiche einer elektrisch isolierenden Schicht angrenzt. Die strukturierten Bereiche dieser Schicht können auf einer Seite der Schichtenebene vorgesehen sein, beispielsweise unterhalb von ihr. Das Material, das je nach Bedeckungsgrad der Grundfläche der Speicherschicht in Form vereinzelter Inseln oder in Form einer löchrigen, mehr oder weniger stark vernetzten Schicht abgeschieden ist, kann bei der Herstellung des Halbleiterspeichers zugleich als Ätzmaske benutzt werden, so daß unterhalb von Zwischenräumen zwischen dem als Ätzmaske dienenden Material die elektrisch isolierende Schicht entfernt ist und unterhalb des Materials selbst strukturierte Bereiche der elektrisch isolierenden Schicht verbleiben. Das als Ätzmaske dienende Material, das elektrisch leitfähig, halbleitend oder auch isolierend bzw. dielektrisch sein kann, kann nach dem Strukturieren der elektrisch isolierenden Schicht wieder entfernt werden.

Vorzugsweise ist vorgesehen, daß die Schichtenebene auf beiden Seiten von dem Speichermedium umgeben ist. Die Schichtenebene kann in einer beliebigen Höhe innerhalb einer Schichtenfolge, die zwei Teilschichten des Speichermediums aufweist, angeordnet sein.

Es kann vorgesehen sein, daß das andere Material unmittelbar auf einer Grenzfläche zu einer Trägerschicht angeordnet ist. Diese Trägerschicht kann beispielsweise eine Elektrodenschicht sein. Alternativ dazu kann sie eine Isolationsschicht aus einem Isolator sein, wodurch die Strompfade erhöhter Stromdichte verlängert werden.

Vorzugsweise ist vorgesehen, daß das Speichermedium elektrisch leitend mit einer ersten Elektrode und mit einer zweiten Elektrode verbunden ist.

Hinsichtlich des Bedeckungsgrades ist vorzugsweise vorgesehen, daß die Grenzfläche zur Trägerschicht zu einem Flächenanteil von zwischen 0,01 und 90 % durch das Speichermedium bedeckt ist. Insbesondere ist vorgesehen, daß diese Grenzfläche zu einem Flächenanteil von zwischen 0,01 und 5 % durch das Speichermedium bedeckt ist. Vor allem sehr kleine Bedeckungsgrade von beispielsweise unter 1 oder 0,5 % führen zu einer erheblichen Steigerung der in der Schichtenebene erzielten Stromdichten, da durch einen entsprechend kleinen Prozentsatz der zur Verfügung stehenden Grundfläche der gesamte Strom fließen muß.

Vorzugsweise ist vorgesehen, daß die Bereiche aus dem anderen Material vereinzelte Inseln sind, die eine durchschnittliche Größe zwischen 0,5 und 100 nm besitzen. Die vereinzelten Inseln können aus dem Material gebildet sein. Sofern das Speichermedium innerhalb der Schichtenebene nur in Form vereinzelter Inseln bzw. Kanäle ausgebildet ist, sind diese Kanäle oberhalb der Schichtenebene durch eine dort zusammenhängende, kompakte und lückenfreie Schicht des Speichermediums miteinander leitend verbunden.

Das Material wird vorzugsweise aus nanokristallinen Partikeln oder aus einem amorphen Isolator gebildet.

Hinsichtlich des Speichermediums sieht eine bevorzugte Ausführungsform vor, daß das Speichermedium im ersten Zustand einen geringeren Kristallisationsgrad und im zweiten Zustand einen höheren Kristallisationsgrad besitzt. Beispielsweise kann das Speichermedium im ersten Zustand überwiegend amorph und im zweiten Zustand überwiegend kristallin, polykristallin oder nanokristallin sein. Das Speichermedium kann vorzugsweise ein Phasenwechselmedium sein.

Das Speichermedium kann ferner ein Chalkogenid oder ein Pnicogenid sein, es kann insbesondere Verbindungen eines der Elemente Germanium, Antimon, Tellur, Silber, Indium, Vanadium oder Verbindungen mit mehreren dieser Elemente enthalten.

Vorzugsweise ist vorgesehen, daß das Speichermedium und das Material zwischen der ersten Elektrode und der zweiten Elektrode angeordnet sind und daß mit Hilfe der Elektroden ein durch das Speichermedium fließender elektrischer Strom zuführbar ist. Hierbei fließt ein Strom beispielsweise von einer Elektrode, die an die Schichtenebene oder an eine erste Teilschicht aus kompaktem Speichermedium angrenzt, durch die Schichtenebene und durch das Speichermedium hindurch bis hin zur zweiten Elektrode oder in umgekehrter Richtung. Je nach Bedeckungsgrad der Grundfläche oder einer entsprechenden Schichtenebene mit dem Material wird dort die Stromdichte lokal an vielen mikroskopisch kleinen Bereichen auf ein Vielfaches erhöht. Je größer der Bedeckungsgrad durch das Material oder durch die damit strukturierte elektrisch isolierende Schicht, desto größer ist die Stromdichte in den durch das Material nicht bedeckten Bereichen, d.h. in dem Speichermedium innerhalb der Schichtenebene.

Vorzugsweise ist vorgesehen, daß der Halbleiterspeicher ein nicht-flüchtiger Phasenwechselspeicher ist.

Die der Erfindung zugrundeliegende Aufgabe wird ferner durch ein Verfahren zum Herstellen eines integrierten Halbleiterspeichers gelöst, das die folgenden Schritte aufweist:
- Ausbilden einer ersten Elektrode,
- Abscheidung eines Materials in der Weise, daß eine Vielzahl von Bereichen aus dem Material gebildet wird, die kleinere Abmessungen besitzen als lithographisch erzeugbare Strukturbreiten, wobei die Abscheidung beendet wird, bevor das Material zu einer ununterbrochenen, lückenlosen Schicht zusammenwächst,
- Abscheiden eines Speichermediums, das einen ersten Zustand geringerer elektrischer Leitfähigkeit und einen zweiten Zustand höherer elektrischer Leitfähigkeit annehmen kann und das zwischen dem ersten und dem zweiten Zustand einen Phasenübergang durchläuft, und
- Ausbilden einer zweiten Elektrode auf oder an dem Speichermedium.

Die Aufgabe wird ferner durch ein alternatives Verfahren gelöst, bei dem die Reihenfolge des zweiten und des dritten Verfahrensschritts vertauscht ist.

Bei den erfindungsgemäßen Verfahren wird vor bzw. nach dem Abscheiden des Speichermediums das Material abgeschieden, und zwar in einer Weise, daß nicht schon zu Beginn des Wachstums eine zusammenhängende, lückenlose Schicht entsteht, sondern zunächst vereinzelte Partikel oder Wachstumskeime entstehen, die, sofern das Wachstum lange genug fortgesetzt wird, auch zu einer mehr oder weniger vernetzten, keinesfalls aber lückenlosen Schicht zusammenwachsen dürfen. Hierzu wird die Prozeßführung des Wachstumsprozesses so gesteuert, daß das Aufwachsverhalten entweder einem Stranski-Krastanov-Wachstum oder einem Vollmer-Weber-Wachstum entspricht. Im Falle des Stranski-Krastanov-Wachstums entsteht zunächst eine Monolage, die jedoch durch eine Rückätzung wieder entfernt wird. Durch das Abscheiden des Speichermediums auf die Vielzahl vereinzelter Inseln aus dem Material oder auf die teilweise vernetzte, mit Lücken oder Öffnungen versehene Schicht aus dem Material wird in Höhe der Schichtenebene der Bedeckungsgrad der Grundfläche der Speicherschicht mit dem Speichermedium auf einen Bruchteil reduziert und in den ausgebildeten Kanälen oder Bereichen aus dem Speichermedium die beim Betrieb des Halbleiterspeichers entstehende Stromdichte vervielfacht.

Vorzugsweise ist vorgesehen, daß das Speichermedium sowohl vor dem Abscheiden des Materials als auch nach dem Abscheiden des Materials abgeschieden wird. Die Schichtenebene mit dem Speichermedium und dem anderen Material kann in einer beliebigen Höhe innerhalb einer Schichtenfolge, die zwei Teilschichten aus kompaktem Speichermedium aufweist, angeordnet sein.

Vorzugsweise ist vorgesehen, daß die Abscheidung des Materials beendet wird, bevor räumlich vereinzelte Inseln aus dem Material zu einer löchrigen Schicht zusammenwachsen. Alternativ dazu ist vorgesehen, daß die Abscheidung des Materials so lange fortgesetzt wird, bis räumlich vereinzelte Inseln aus dem Material zu einer löchrigen Schicht zusammenwachsen. Zur Erzielung besonders hoher Stromdichten ist die zweite Variante bevorzugt, wohingegen bei der ersten Variante eine Gefahr eines nicht geschlossenen elektrischen Kontakts zwischen der Speicherschicht und der unteren Elektrode geringer ist als bei der zweiten Variante.

Weiterhin sieht die Erfindung vor, daß vor dem Abscheiden des Materials eine elektrisch isolierende Schicht abgeschieden wird und daß die elektrisch isolierende Schicht nach dem Abscheiden des Materials mit diesem als Ätzmaske geätzt wird. In diesem Fall erhöht sie die Tiefe der mit Material gefüllten Bereiche und verlängert die Kanäle hoher Stromdichte zwischen der unteren Elektrode und der über der Schichtenebene angeordneten kompakten Schicht, die ausschließlich aus dem Speichermedium besteht. Dadurch wird ein größerer Anteil des gesamten Speichermedium der höheren Stromdichte ausgesetzt als ohne Mikro- oder Nanostrukturen aus dem Material.

Beim Abscheiden des Speichermediums werden Bereiche, in denen die elektrisch isolierende Schicht geätzt wurde, mit dem Speichermedium gefüllt. Dadurch wird der elektrische Kontakt zwischen der unteren Elektrode und dem Speichermedium hergestellt.

Durch das Abscheiden des Materials und des Speichermediums wird eine Lage, d.h. Schichtenebene mit einer löchrigen Schicht hergestellt, deren Öffnungen kleiner sind als eine lithographisch dimensionierbare Strukturbreite, beispielsweise kleiner als eine zum Strukturieren der Elektroden oder der Speicherschicht verwendeten lithographischen Strukturbreite. In der Regel sind die isolierenden Strukturen noch weitaus feinkörniger; das Größenverhältnis zur lithographisch üblicherweise eingesetzten Strukturbreite kann bis zu bis zu einem Hundertstel oder sogar bis zu einem Zehntausendstel betragen und ermöglicht eine lithographisch nicht erreichbare Nano- oder Mikrostrukturierung. Je nach Grad der Bedeckung der Speicherschichtgrundfläche mit den Bereichen aus dem Material kann die erforderliche Temperatur bzw. die einzusetzende Stromstärke angepaßt werden.

Vorzugsweise ist vorgesehen, daß ein Speichermedium abgeschieden wird, das im ersten Zustand einen geringeren Kristallisationsgrad und im zweiten Zustand einen höheren Kristallisationsgrad besitzt. Das Speichermedium kann beispielsweise im ersten Zustand überwiegend amorph und im zweiten Zustand überwiegend kristallin, polykristallin oder nanokristallin sein.

Die Erfindung wird nachstehend in Bezug auf die Figuren 1 bis 12 beschrieben. Es zeigen:
- Figur 1: einen erfindungsgemäßen Halbleiterspeicher,
- die Figuren 2 bis 8: verschiedene Verfahrensschritte eines erfindungsgemäßen Herstellungsverfahrens zur Herstellung des Halbleiterspeichers aus Figur 1,
- Figur 9A und 9B: einen vergrößerten Querschnitt durch eine Schichtenfolge aus zwei Elektroden und einem dazwischen angeordneten Speichermedium mit einer Schichtenebene mit isolierenden Fremdpartikeln,
- Figur 10: eine schematische Darstellung von Stromkanälen und von Phasen des Speichermediums,
- Figur 11: zwei Zustände unterschiedlicher elektrischer Leitfähigkeit des Speichermediums,
- Figur 12: eine schematische Darstellung der Zusammensetzung der Speicherschicht in Höhe der Schichtenebene und
- Figur 13: eine zweite, alternative Ausführungsform hinsichtlich der Zusammensetzung der Speicherschicht in Höhe der Schichtenebene.

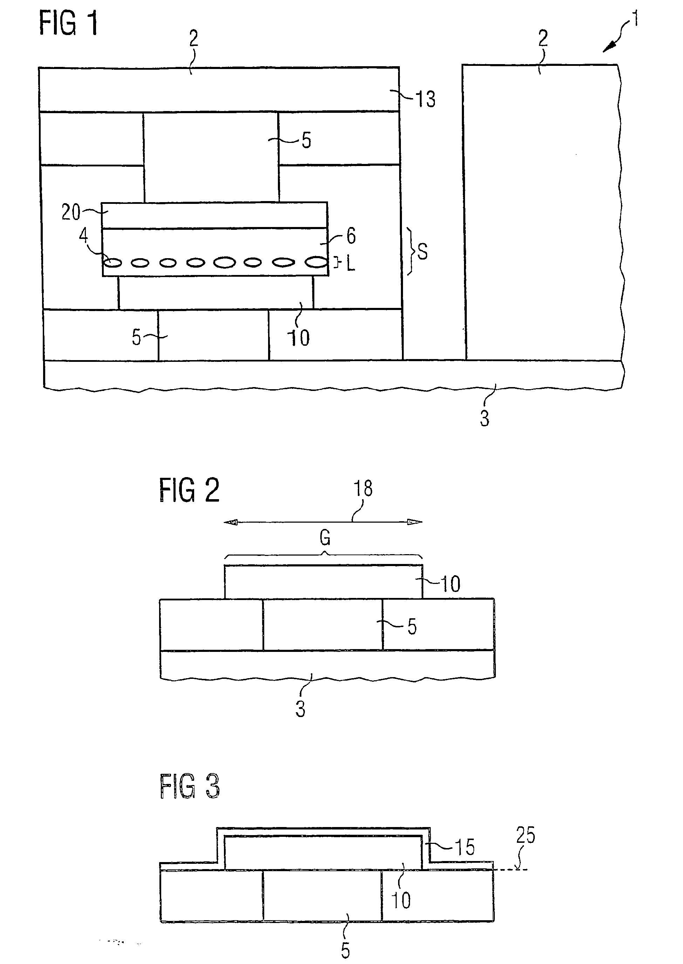

Figur 1 zeigt eine schematische Querschnittsansicht eines erfindungsgemäßen Halbleiterspeichers 1, bei dem eine Speicherzelle 2, die stellvertretend für die übrigen Speicherzellen steht, eine erste Elektrode 10, eine zweite Elektrode 20 und dazwischen ein Speichermedium 6 aufweist. Die Elektroden 10, 20 sind durch Kontaktverbindungen 5 mit entsprechenden Leiterbahnen oder mit dem Substrat 3 und einer höhergelegenen Leiterbahn 13 verbunden. In lateraler Richtung ist die Speicherzelle durch entsprechende Isolierungen gegenüber benachbarten Speicherzellen abgeschirmt.

Erfindungsgemäß ist innerhalb des Speichermediums 6 eine Lage bzw. Schichtenebene vorgesehen, in der Fremdpartikel aus einem Material 4 eingebaut sind, wodurch in Höhe dieser Schichtenebene der Anteil der Grundfläche der zwischen den Elektroden 10, 20 gelegenen Speicherschicht, der mit dem Speichermedium bedeckt ist, auf einen Bruchteil oder jedenfalls auf einen Teil der gesamten Grundfläche verringert wird.

Erfindungsgemäß weist die Speicherschicht S eine Schichtenebene L auf, in der Bereiche aus einem anderen Material 4 als dem Speichermedium 6 verteilt sind und in der das Speichermedium 6 zwischen den Bereichen aus dem anderen Material 4 angeordnet ist, wobei die Bereiche aus dem anderen Material 4 Abmessungen besitzen, die kleiner sind als eine lithographisch dimensionierbare Strukturbreite 18, beispielsweise als die Strukturbreite der Speicherschicht S oder einer der Elektroden 10, 20. Ferner können die Bereiche aus dem anderen Material 4; 15 strukturierte Bereiche einer strukturierten elektrisch isolierenden Schicht 15 mit umfassen oder ausschließlich aus ihnen bestehen.

Erfindungsgemäß werden dadurch in Höhe dieser Schichtenebene 11 erhöhte Stromdichten in dem Speichermedium zwischen einander benachbarten Bereichen aus dem isolierenden Material erzwungen. Diese Stromdichten erhitzen dort das Speichermedium stärker als im Falle einer Speicherschicht, die ausschließlich aus einem homogenen Speichermedium besteht. Von der Schichtenebene L aus setzt sich der schon bei niedrigerem Gesamtstrom eingetretene Phasenübergang durch das restliche Material des Speichermediums hindurch fort und ändert mit geringerem Gesamtstrom den Zustand des Speichermediums. Dadurch wird die Speicherzelle mit geringerem Energieverbrauch umprogrammiert.

Die Figuren 2 bis 8 zeigen den auf diese Weise hergestellten Halbleiterspeicher in verschiedenen Verfahrensschritten eines erfindungsgemäßen Verfahrens. Gemäß Figur 2 wird auf ein Halbleitersubstrat 3, das in den Figuren 3 bis 8 nicht eigens dargestellt ist, eine erste, untere Elektrode 10 aufgebracht, deren Grundfläche G lithographisch strukturiert wird. Die Grundfläche G der Elektrode 10 besitzt die Strukturbreite 18. Die Elektrode 10 kann beispielsweise mit Hilfe einer Kontaktverbindung 5 mit dem Substrat 3 elektrisch verbunden sein oder durch diese Kontaktverbindung 5 mit benachbarten Strukturen verbunden sein.

Auf die erste Elektrode 10 wird eine elektrisch isolierende Schicht 15 aufgebracht, wie in Figur 3 dargestellt. Die elektrisch isolierende Schicht 15 ist eine zu strukturierende Schicht, die in strukturierter Form dazu dient, Kanäle erhöhter Stromdichte zu verlängern und so einen größeren Anteil des Speichermediums 6 der erhöhten Stromdichte auszusetzen. In diesem Fall wird das Material 4 auf die Oberfläche der elektrisch isolierenden Schicht 15 aufgewachsen und anschließend als Ätzmaske zur Strukturierung der isolierenden Schicht 15 eingesetzt. Anschießend kann das Material 4 wieder entfernt werden. Diese Schritte sind in den nachfolgenden Figuren dargestellt.

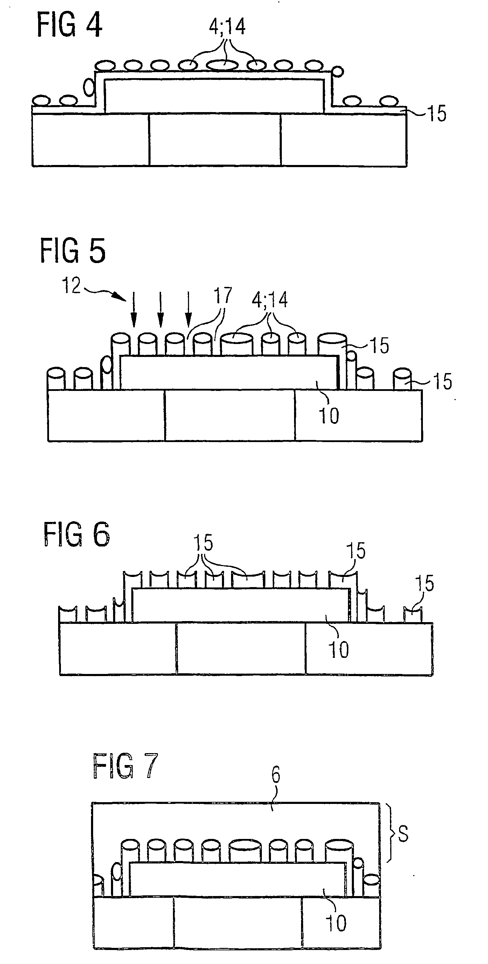

Gemäß Figur 4 wird ein Material 4 statt auf die Elektrode 10 auf die elektrisch isolierende Schicht 15 aufgebracht. Das Material muß so aufgebracht werden, daß vereinzelte Inseln 14 aus dem Material 4 entstehen, die räumlich voneinander getrennt, d.h. vereinzelt sind und erst bei fortschreitendem Wachstum allmählich zu einer vernetzten, zunächst mit Lücken versehenen Schicht zusammenwachsen.

Gemäß Figur 5 wird eine anisotrope Ätzung vorgenommen, wie durch die Pfeile 12 dargestellt, wodurch in Zwischenräumen zwischen den Partikeln 14 aus dem Material 4 die Isolationsschicht 15 geätzt wird. Sofern die elektrisch isolierende Schicht 15 aus einem isolierenden Material besteht, beispielsweise aus Siliziumdioxid, wird durch ihre Strukturierung die Höhe elektrisch isolierender Bereiche auf der ersten Elektrode 10 erhöht. Dadurch werden beim Betrieb des Halbleiterspeichers längere Stromkanäle erhöhter Stromdichte erzeugt.

Gemäß Figur 6 kann das Material 4, das in Figur 5 als Ätzmaske für die elektrisch isolierende Schicht 15 verwendet wurde, wieder entfernt werden. Dies ist insbesondere von Vorteil, wenn das Material 4 elektrisch leitfähig oder nicht ausreichend temperaturstabil ist, um der beim wiederholtem Umprogrammieren entstehenden Wärmezufuhr standzuhalten. Es kann aber ebenso auf der strukturierten Schicht 15 verbleiben, wie in den folgenden Figuren dargestellt.

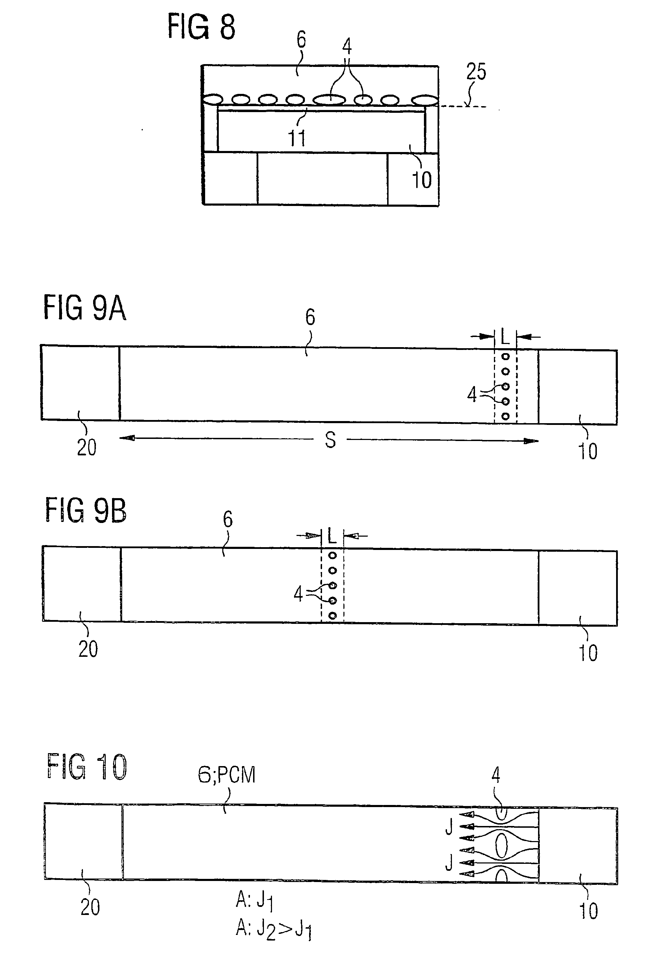

Gemäß Figur 7 wird auf die je nach Wachstumsdauer noch vereinzelten oder bereits teilweise zusammengewachsenen Bereiche aus dem isolierenden Material 4 das Speichermedium 6 abgeschieden, das vorzugsweise ein Phasenwechselmedium ist. Anschließend kann die so erzeugte Speicherschicht strukturiert werden, wie in Figur 8 dargestellt, wodurch die Grundfläche der Speicherschicht im wesentlichen an die Grundfläche der ersten Elektrode 10 angepaßt wird. Die Figur 8 stellt zugleich eine alternative Ausführungsform des erfindungsgemäßen Verfahrens dar, bei dem in einem Verfahrensstadium, das den Figuren 3 und 4 entspricht, das Material 4 statt auf eine elektrisch isolierende Schicht 15 unmittelbar auf die Elektrode 10 oder auf eine zu ihr gehörige Elektrodenschicht 11 aufgebracht wurde.

Von Figur 8 ausgehend braucht nur noch die zweite, obere Elektrode 20 aufgebracht, strukturiert und über eine Kontaktverbindung 5 mit einer Leiterbahn 13 verbunden zu werden, um den in Figur 1 dargestellten Halbleiterspeicher 1 mit der erfindungsgemäß ausgebildeten Speicherzelle 2 zu erhalten.

In den Figuren 4 bis 8 ist die Höhe der Lage bzw. Schichtenebene L durch die vertikale Position der Bereiche aus isolierendem Material 4 vorgegeben.

Figur 9A zeigt einen Querschnitt durch eine Schichtenfolge aus erster Elektrode 10, Speichermedium 6 und zweiter Elektrode 20, bei der in der Speicherschicht im Bereich einer Schichtenebene L anstelle kompakten Materials des Speichermediums 6 zusätzlich Bereiche aus einem Material 4 vorhanden sind. In Höhe der Schichtenebene, die in Figur 8 durch den horizontal ausgerichteten Doppelpfeil dargestellt ist, ist die zwischen den Elektroden angeordnete Speicherschicht nur über einen statistischen Bruchteil ihrer Grundfläche elektrisch leitfähig.

Figur 9B zeigt einen der Figur 9A entsprechenden Querschnitt durch die Schichtenfolge zwischen den Elektroden 10 und 20, wobei die Schichtenebene L etwa in der Mitte zwischen zwei Teilschichten aus jeweils kompaktem Speichermedium angeordnet ist. Die Schichtenebene kann auch in einer beliebigen Lage zwischen den Elektroden 10, 20 angeordnet sein.

Figur 10 zeigt einen den Figuren 9A und 9B entsprechenden Querschnitt durch die Schichtenfolge aus den Elektroden 10 und 20 und der Speicherschicht mit dem Speichermedium 6, wobei anhand zweier Zwischenräume zwischen Bereichen aus dem Material 4 der Verlauf elektrischer Feldlinien dargestellt ist. Anhand der Komprimierung der Feldlinien zwischen benachbarten Bereichen aus dem isolierenden Material 4 ist die Stromdichte J gegenüber derjenigen im massiven, lückenlos ausgebildeten Speichermedium 6 erhöht. Figur 10 zeigt schematisch für zwei verschiedene Phasen oder Zustände des Speichermediums 6, nämlich die Phasen A und B, daß verschiedene Programmierströme J₁ und J₂ erforderlich sind, um das Speichermedium in die Phase A oder B zu bringen. Beispielsweise kann der Zustand A ein kristalliner Zustand sein, der - bei einer Temperatur von oberhalb 300° C erreicht wird und daher zum Programmieren einen Strom J₁ benötigt. Um einen amorphen Zustand B niedrigerer Leitfähigkeit zu erhalten, muß beispielsweise ein Strom J₂ aufgewandt werden, der größer ist als der Strom J₁ und der bewirkt, daß das Speichermedium 6 teilweise geschmolzen wird und in Folge der metallischen, hoch wärmeleitfähigen Elektroden 10, 20 innerhalb kürzester Zeit wieder auf Raumtemperatur abgekühlt, d.h. abgeschreckt wird. Dadurch bleibt das atomare Gerüst des Speichermediums 6 in einem amorphen, ungeordneten Zustand vergleichsweise geringerer elektrischer Leitfähigkeit im Vergleich zum kristallinen oder polykristallinen Zustand A.

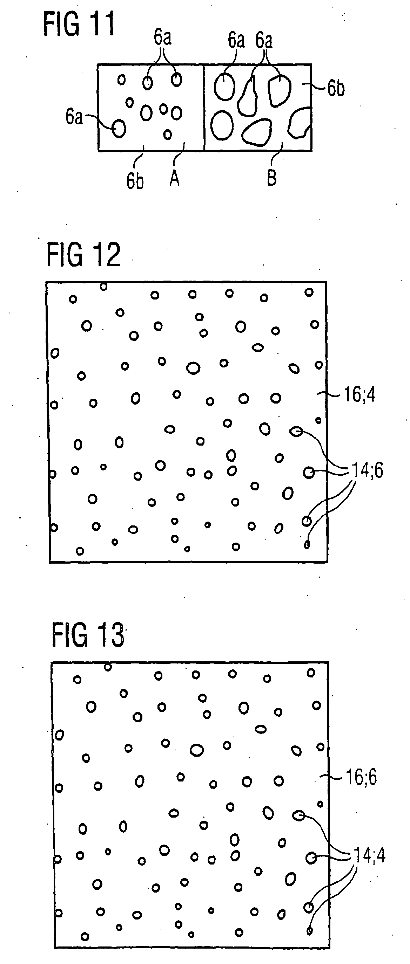

Figur 11 zeigt zwei Zustände A und B, die das Speichermedium 6 je nach Temperatur annehmen kann. Im ersten Zustand A, den das Speichermedium 6 bei geringerer Temperatur annimmt, liegt ein relativ kleiner Anteil des Speichermediums 6 in Form kristalliner Bereiche 6a vor. Der übrige Anteil des Speichermediums 6 kann in Form einer amorphen Matrix 6b vorliegen. Im Zustand B, den das Speichermedium 6 bei höherer Temperatur annimmt, liegt ein größerer Anteil des Speichermediums 6 in Form kristalliner Bereiche 6a vor als im Zustand A. Beispielsweise kann das Speichermedium im Zustand A überwiegend amorph und im Zustand B überwiegend kristallin, polykristallin oder nanokristallin sein. Die Zustände A und B beziehen sich auf die Materialeigenschaften des Speichermediums 6. Während des Betriebs des integrierten Halbleiterspeichers braucht das Speichrmedium 6 jedoch nur im Bereich der Schichtenebene L einen Phasenübergang zu durchlaufen, um eine Information zu speichern.

Gemäß Figur 13 kann die Speicherebene in Höhe der Schichtenebene überwiegend aus dem Speichermedium 6 bestehen; dieses bildet in diesem Fall eine zusammenhängende, löchrige Schicht 16, in deren Öffnungen ist das Material 4 in Form von räumlich vereinzelten Inseln 14 eingelagert. Bei dem vergleichsweise großen Bedeckungsgrad der Grundfläche der Speicherschicht mit dem Speichermedium 6 wird nur eine geringe Reduzierung der Programmierströme erzielt.

Figur 12 veranschaulicht eine Ausführungsform, bei der das Material 4 so lange aufgewachsen wurde, bis es eine vernetzte, zusammenhängende, aber mit Poren oder Lücken versehene Schicht 16 bildet. In dem dargestellten horizontalen, aus der Draufsicht betrachteten Querschnitt ist das Material des Speichermediums 6 in Form vieler vereinzelter Inseln 14 angeordnet, die in der dreidimensionalen Struktur Kanäle bilden, die zwischen der ersten Elektrode 10 und dem Bulk-Material des Speichermediums 6 verlaufen, welches näher zur zweiten Elektrode 20 angeordnet ist.

Das isolierende Material 4 kann in Form von kristallinen Nanopartikeln abgeschieden und als Ätzmaske verwendet werden. Geeignete Abscheideverfahren sind beispielsweise CVD, PVD, Sputtern, das Spin-on-Verfahren, die Laserablation oder Aufdampfen. Ferner kommt Atomic Layer Deposition in Betracht. Auf die aufgewachsenen Bereiche aus dem Material 4 wird anschließend, sofern nicht vorher noch die elektrisch isolierende Schicht 15 strukturiert wird, das Speichermedium abgeschieden, das vorzugsweise ein Phasenwechselmaterial ist, insbesondere ein Chalkogenid oder Pnicogenid. Geeignete Phasenwechselmedien sind beispielsweise Verbindungen aus Germanium, Antimon und Tellur oder solche, die zusätzlich Silber enthalten. Das Material 4 kann auch aus schwach elektrisch leitfähigen Materialien bestehen, beispielsweise aus Silizium oder anderen halbleitenden Materialien. Entscheidend ist, daß die Leitfähigkeit in dem Material 4 geringer ist als in dem Material des Speichermediums 6. Dadurch, daß das Material 4 entweder durch ein Stranski-Krastanov-Wachstum oder durch ein Vollmer-Weber-Wachstum aufgewachsen wird, entsteht ein Muster mit einer vorgegebenen Punktdichte der aufgewachsenen Partikel. Bei länger andauerndem Wachstum entsteht eine aus vielen Mikro- oder Nanopartikeln gebildete, zusammenhängende Fläche, die aus vielen Einzelsegmenten zusammengesetzt ist. Bei kürzeren Wachstumszeiten hingegen bleiben die vielen aufgewachsenen Einzelsegmente voneinander getrennt. Alternativ zum Stranski-Krastanov-Wachstum mit anschließender Rückätzung der zunächst gebildeten Monolage und alternativ zum Vollmer-Weber-Wachstum können auch selbstorganisierte Cluster aus beispielsweise Metallen oder Metalloxiden eingesetzt werden, um die elektrisch leitfähigen Flächenbereiche über der Grundfläche der Speicherschicht in Höhe der Schichtenebene L zu verringern. Ferner kann jedes Material eingesetzt werden, das ausreichend temperaturstabil und vorzugsweise auch elektrisch isolierend ist. Selbst Materialien, die nicht temperaturstabil sind, können als Ätzmaske zur Strukturierung einer elektrisch isolierenden Schicht eingesetzt werden, wenn sie danach wieder entfernt werden.

Ferner kann eine Mikrophasenseparation von Block-Copolymeren eingesetzt werden, um eine selbstorganisierte Teilbedeckung der Grundfläche zu erreichen. Die lateralen Abmessungen der Strukturen, die aus dem Material 4 und dem komplementär den Raum füllenden Speichermedium 6 gebildet werden, liegen typischerweise im Nanometerbereich.

### Bezugszeichenliste

- 1: Halbleiterspeicher
- 2: Speicherzelle
- 3: Substrat
- 4: Material
- 5: Kontaktverbindung
- 6: Speichermedium
- 6a: kristalliner Bereich
- 6b: Matrix
- 10: erste Elektrode
- 11: Elektrodenschicht
- 12: Ätzung der elektrisch isolierenden Schicht
- 13: Leiterbahn
- 14: vereinzelte Insel
- 15: elektrisch isolierende Schicht
- 16: zusammenhängende löchrige Schicht
- 17: Zwischenraum zwischen vereinzelten Inseln
- 18: lithographische Strukturbreite
- 20: zweite Elektrode
- 25: Grenzfläche
- A, B: Zustände des Speichermediums
- G: Grundfläche
- J: erhöhte Stromdichte
- J₁, J₂: Programmierströme
- L: Schichtenebene
- PCM: Phasenwechselmedium
- S: Speicherschicht

## Patentansprüche

1. Integrierter Halbleiterspeicher (1) mit einer Speicherzelle (2), die eine Speicherschicht (S) mit einem Speichermedium (6) aufweist, das einen ersten Zustand (A) geringerer elektrischer Leitfähigkeit und einen zweiten Zustand (B) höherer elektrischer Leitfähigkeit annehmen kann und das zwischen dem ersten und dem zweiten Zustand einen Phasenübergang durchläuft,
- wobei der jeweilige Zustand (A, B) des Speichermediums (6) mit Hilfe eines elektrischen Stroms (J), der durch das Speichermedium fließt, einstellbar ist, **dadurch gekennzeichnet, daß** - die Speicherschicht (S) eine Schichtenebene (L) aufweist, in der Bereiche aus einem anderen Material (4) als dem Speichermedium (6) verteilt sind und in der das Speichermedium (6) zwischen den Bereichen aus dem anderen Material (4) angeordnet ist,
- wobei die Bereiche aus dem anderen Material (4) Abmessungen besitzen, die kleiner sind als eine lithographisch dimensionierbare Strukturbreite (18), und
- wobei das andere Material (4) an strukturierte Bereiche einer elektrisch isolierenden Schicht (15) angrenzt.

2. Halbleiterspeicher nach Anspruch 1,
**dadurch gekennzeichnet, daß**
die Schichtenebene (L) auf beiden Seiten von dem Speichermedium (6) umgeben ist.

3. Halbleiterspeicher nach Anspruch 1 oder 2,
**dadurch gekennzeichnet, daß**
das andere Material (4) unmittelbar auf einer Grenzfläche (25) zu einer Trägerschicht (15; 10; 11) angeordnet ist.

4. Halbleiterspeicher nach Anspruch 3,
**dadurch gekennzeichnet, daß**
die Trägerschicht eine Elektrodenschicht (11) ist.

5. Halbleiterspeicher nach einem der Ansprüche 1 bis 4,
**dadurch gekennzeichnet, daß**
das Speichermedium (6) elektrisch leitend mit einer ersten Elektrode (10) und mit einer zweiten Elektrode (20) verbunden ist.

6. Halbleiterspeicher nach Anspruche 4 oder 5,
**dadurch gekennzeichnet, daß**
die Grenzfläche (25) zur Trägerschicht zu einem Flächenanteil von zwischen 0,01 und 90 % durch das Speichermedium (6) bedeckt ist.

7. Halbleiterspeicher nach einem der Ansprüche 5 bis 6,
**dadurch gekennzeichnet, daß**
die Grenzfläche (25) zur Trägerschicht zu einem Flächenanteil von zwischen 0,01 und 5 % durch das Speichermedium (6) bedeckt ist.

8. Halbleiterspeicher nach einem der Ansprüche 1 bis 6,
**dadurch gekennzeichnet, daß**
die Bereiche aus dem anderen Material (4) vereinzelte Inseln (14) sind, die eine durchschnittliche Größe zwischen 0,5 und 100 nm besitzen.

9. Halbleiterspeicher nach einem der Ansprüche 1 bis 8,
**dadurch gekennzeichnet, daß** das Material (4) aus nanokristallinen Partikeln oder aus einem amorphen Isolator besteht.

10. Halbleiterspeicher nach einem der Ansprüche 1 bis 9,
**dadurch gekennzeichnet, daß**
das Speichermedium (6) im ersten Zustand (A) einen geringeren Kristallisationsgrad und im zweiten Zustand (B) einen höheren Kristallisationsgrad besitzt.

11. Halbleiterspeicher nach einem der Ansprüche 1 bis 10,
**dadurch gekennzeichnet, daß**
das Speichermedium (6) ein Chalkogenid oder ein Pnicogenid enthält.

12. Halbleiterspeicher nach einem der Ansprüche 6 bis 11,
**dadurch gekennzeichnet, daß**
das Speichermedium (6) und das Material (4) zwischen der ersten Elektrode (10) und der zweiten Elektrode (20) angeordnet sind und mit Hilfe der Elektroden (10, 20) ein durch das Speichermedium (6) fließender elektrischer Strom (J) zuführbar ist.

13. Halbleiterspeicher nach einem der Ansprüche 1 bis 12,
**dadurch gekennzeichnet, daß**
der Halbleiterspeicher (1) ein nicht-flüchtiger Phasenwechselspeicher ist.

14. Verfahren zum Herstellen eines integrierten Halbleiterspeichers, das die folgenden Schritte aufweist:
- Ausbilden einer ersten Elektrode (10),
- Abscheiden einer elektrisch isolierenden Schicht (15),
- Abscheiden eines Materials (4) in der Weise, daß eine Vielzahl von Bereichen aus dem Material (4) gebildet wird, die kleinere Abmessungen besitzen als lithographisch erzeugbare Strukturbreiten (18), wobei die Abscheidung beendet wird, bevor das Material (4) zu einer ununterbrochenen, lückenlosen Schicht zusammenwächst,
- Strukturieren der elektrisch isolierenden Schicht (15), wobei die Bereiche aus dem Material (4) als Ätzmaske verwendet werden,
- Abscheiden eines Speichermediums (6), das einen ersten Zustand (A) geringerer elektrischer Leitfähigkeit und einen zweiten Zustand (B) höherer elektrischer Leitfähigkeit annehmen kann und das zwischen dem ersten und dem zweiten Zustand einen Phasenübergang durchläuft, und
- Ausbilden einer zweiten Elektrode (20) auf oder an dem Speichermedium (6).

15. Verfahren zum Herstellen eines integrierten Halbleiterspeichers, das die folgenden Schritte aufweist:
- Ausbilden einer ersten Elektrode (10),
- Abscheiden eines Speichermediums (6), das einen ersten Zustand (A) geringerer elektrischer Leitfähigkeit und einen zweiten Zustand (B) höherer elektrischer Leitfähigkeit annehmen kann und das zwischen dem ersten und dem zweiten Zustand einen Phasenübergang durchläuft,
- Abscheiden einer elektrisch isolierenden Schicht (15),
- Abscheiden eines Materials (4) in der Weise, daß eine Vielzahl von Bereichen aus dem Material (4) gebildet wird, die kleinere Abmessungen besitzen als lithographisch erzeugbare Strukturbreiten (18), wobei die Abscheidung beendet wird, bevor das Material (4) zu einer ununterbrochenen, lückenlosen Schicht zusammenwächst,
- Strukturieren der elektrisch isolierenden Schicht (15), wobei die Bereiche aus dem Material (4) als Ätzmaske verwendet werden, und
- Ausbilden einer zweiten Elektrode (20).

16. Verfahren nach Anspruch 14 oder 15,
**dadurch gekennzeichnet, daß**
das Speichermedium (6) sowohl vor dem Abscheiden des Materials (4) als auch nach dem Abscheiden des Materials (4) abgeschieden wird.

17. Verfahren nach einem der Ansprüche 14 bis 16,
**dadurch gekennzeichnet, daß**
die Abscheidung des Materials (4) beendet wird, bevor räumlich vereinzelte Inseln (14) aus dem Material (4) zu einer löchrigen Schicht zusammenwachsen.

18. Verfahren nach einem der Ansprüche 14 bis 16,
**dadurch gekennzeichnet, daß**
die Abscheidung des Materials (4) so lange fortgesetzt wird, bis räumlich vereinzelte Inseln (14) aus dem Material (4) zu einer löchrigen Schicht (16) zusammenwachsen.

19. Verfahren nach einem der Ansprüche 14 bis 18,
**dadurch gekennzeichnet, daß**
bei dem Abscheiden des Speichermediums (6) Bereiche, in denen die elektrisch isolierende Schicht (15) geätzt wird, mit dem Speichermedium (6) gefüllt werden.

20. Verfahren nach einem der Ansprüche 14 bis 19,
**dadurch gekennzeichnet, daß**
durch das Abscheiden des Materials (4) und durch das Abscheiden des Speichermediums (6) eine Schichtenebene (L) mit einer löchrigen Schicht (16) hergestellt wird, deren Öffnungen kleiner sind als eine lithographisch dimensionierbare Strukturbreite (18).

21. Verfahren nach einem der Ansprüche 14 bis 20,
**dadurch gekennzeichnet, daß**
ein Speichermedium (6) abgeschieden wird, das im ersten Zustand (A) einen geringeren Kristallisationsgrad und im zweiten Zustand (B) einen höheren Kristallisationsgrad besitzt.

## Claims

1. Integrated semiconductor memory (1) comprising a memory cell (2) having a storage layer (S) comprising a storage medium (6), which can assume a first state (A) of lower electrical conductivity and a second state (B) of higher electrical conductivity and which undergoes a phase transition between the first and second states,
- the respective state (A, B) of the storage medium (6) being programmable by means of an electric current (J) flowing through the storage medium, **characterized**
**in that**
- the storage layer (S) has a layer plane (L) in which regions made from a different material (4) than the storage medium (6) are distributed and in which the storage medium (6) is arranged between the regions made from the different material (4),
- the regions made from the different material (4) having dimensions which are smaller than a feature size (18) that can be dimensioned lithographically, and
- the different material (4) adjoining patterned regions of an electrically insulating layer (15).

2. Semiconductor memory according to Claim 1,
**characterized in that**
the layer plane (L) is surrounded by the storage medium (6) on both sides.

3. Semiconductor memory according to Claim 1 or 2,
**characterized in that**
the different material (4) is arranged directly on an interface (25) with a carrier layer (15; 10; 11).

4. Semiconductor memory according to Claim 3,
**characterized in that**
the carrier layer is an electrode layer (11).

5. Semiconductor memory according to one of Claims 1 to 4,
**characterized in that**
the storage medium (6) is electrically conductively connected to a first electrode (10) and to a second electrode (20).

6. Semiconductor memory according to Claim 4 or 5,
**characterized in that**
an area proportion of the interface (25) with the carrier layer of between 0.01 and 90% is covered by the storage medium (6).

7. Semiconductor memory according to one of Claims 5 to 6,
**characterized in that**
an area proportion of the interface (25) with the carrier layer of between 0.01 and 5% is covered by the storage medium (6).

8. Semiconductor memory according to one of Claims 1 to 6,
**characterized in that**
the regions made from the different material (4) are isolated islands (14) having an average size of between 0.5 and 100 nm.

9. Semiconductor memory according to one of Claims 1 to 8,
**characterized in that**
the material (4) comprises nanocrystalline particles or an amorphous insulator.

10. Semiconductor memory according to one of Claims 1 to 9,
**characterized in that**
the storage medium (6) has a lower degree of crystallization in the first state (A) and a higher degree of crystallization in the second state (B).

11. Semiconductor memory according to one of Claims 1 to 10,
**characterized in that**
the storage medium (6) contains a chalcogenide or a pnicogenide.

12. Semiconductor memory according to one of Claims 6 to 11,
**characterized in that**
the storage medium (6) and the material (4) are arranged between the first electrode (10) and the second electrode (20) and an electric current (J) flowing through the storage medium (6) can be fed with the aid of the electrodes (10, 20).

13. Semiconductor memory according to one of Claims 1 to 12,
**characterized in that**
the semiconductor memory (1) is a nonvolatile phase change memory.

14. Method for producing an integrated semiconductor memory, having the following steps:
- formation of a first electrode (10),
- deposition of an electrically insulating layer (15),
- deposition of a material (4) in such a way as to form a multiplicity of regions made from the material (4) which have smaller dimensions than feature sizes (18) that can be produced lithographically, the deposition being ended before the material (4) grows together to form an uninterrupted layer having no gaps,
- patterning of the electrically insulating layer (15), the regions made from the material (4) being used as an etching mask,
- deposition of a storage medium (6), which can assume a first state (A) of lower electrical conductivity and a second state (B) of higher electrical conductivity and which undergoes a phase transition between the first and second states, and
- formation of a second electrode (20) on or at the storage medium (6).

15. Method for producing an integrated semiconductor memory, having the following steps:
- formation of a first electrode (10),
- deposition of a storage medium (6), which can assume a first state (A) of lower electrical conductivity and a second state (B) of higher electrical conductivity and which undergoes a phase transition between the first and second states,
- deposition of an electrically insulating layer (15),
- deposition of a material (4) in such a way as to form a multiplicity of regions made from the material (4) which have smaller dimensions than feature sizes (18) that can be produced lithographically, the deposition being ended before the material (4) grows together to form an uninterrupted layer having no gaps,
- patterning of the electrically insulating layer (15), the regions made from the material (4) being used as an etching mask, and
- formation of a second electrode (20).

16. Method according to Claim 14 or 15,
**characterized in that**
the storage medium (6) is deposited both prior to the deposition of the material (4) and after the deposition of the material (4).

17. Method according to one of Claims 14 to 16,
**characterized in that**
the deposition of the material (4) is ended before spatially isolated islands (14) made from the material (4) grow together to form a perforated layer.

18. Method according to one of Claims 14 to 16,
**characterized in that**
the deposition of the material (4) is continued until spatially isolated islands (14) made from the material (4) grow together to form a perforated layer (16).

19. Method according to one of Claims 14 to 18,
**characterized in that**
regions in which the electrically insulating layer (15) is etched are filled with the storage medium (6) during the deposition of the storage medium (6).

20. Method according to one of Claims 14 to 19,
**characterized in that**
the deposition of the material (4) and the deposition of the storage medium (6) result in the production of a layer plane (L) comprising a perforated layer (16) having openings which are smaller than a feature size (18) that can be dimensioned lithographically.

21. Method according to one of Claims 14 to 20,
**characterized in that**
a storage medium (6) is deposited which has a lower degree of crystallization in the first state (A) and a higher degree of crystallization in the second state (B).

## Revendications

1. Mémoire (1) intégrée à semi-conducteurs ayant une cellule (2) de mémoire, qui a une couche (S) de mémoire ayant un support (6) de données, qui peut prendre un premier état (A) de petite conductivité électrique et un deuxième état (B) de grande conductivité électrique et qui passe par une transition de phase entre le premier et le deuxième état,
- dans laquelle l'état (A, B) respectif du support (6) de données peut être réglé à l'aide d'un courant (J) électrique qui passe dans le support de données, **caractérisée en ce que**
- la couche (S) de mémoire a un plan (L) de couche, dans lequel sont réparties des parties en un matériau (4) autre que le support (6) de données et dans lequel le support (6) de données est disposé entre les parties en l'autre matériau (4),
- dans laquelle les parties en l'autre matériau (4) ont des dimensions qui sont plus petites qu'une largeur (18) de structure pouvant être dimensionnée lithographiquement, et
- dans laquelle l'autre matériau (4) est voisin de parties structurées d'une couche (15) isolante du point de vue électrique.

2. Mémoire à semi-conducteurs suivant la revendication 1,
**caractérisée en ce que**
le plan (L) de couche est entouré des deux côtés du support (6) de données.

3. Mémoire à semi-conducteurs suivant la revendication 1 ou 2,
**caractérisée en ce que**
l'autre matériau (4) est disposé directement sur une interface(25) avec une couche (15 ; 10, 11) de support.

4. Mémoire à semi-conducteurs suivant la revendication 3,
**caractérisée en ce que**
la couche de support est une couche (11) d'électrode.

5. Mémoire à semi-conducteurs suivant l'une des revendications 1 à 4,
**caractérisée en ce que**
le support (6) de données est relié d'une manière conductrice de l'électricité à une première électrode (10) et à une deuxième électrode (20).

6. Mémoire à semi-conducteurs suivant la revendication 4 ou 5,
**caractérisée en ce que**
l'interface (25) avec la couche de support est recouverte par le support (6) de données pour une proportion de la surface comprise entre 0,01 et 90 %.

7. Mémoire à semi-conducteurs suivant l'une des revendications 5 à 6,
**caractérisée en ce que**
l'interface (25) avec la couche de support est recouverte par le support (6) de données pour une proportion de la surface comprise entre 0,01 et 5 %.

8. Mémoire à semi-conducteurs suivant l'une des revendications 1 à 6,
**caractérisée en ce que**
les parties en l'autre matériau (4) sont des ilots (14) individualisés qui ont une dimension moyenne comprise entre 0,5 et 100 nm.

9. Mémoire à semi-conducteurs suivant l'une des revendications 1 à 8,
**caractérisée en ce que**
le matériau (4) est constitué de particules nanocristallines ou d'un isolant amorphe.

10. Mémoire à semi-conducteurs suivant l'une des revendications 1 à 9,
**caractérisée en ce que**
le support (6) de données a dans le premier état (A) un degré de cristallisation qui est petit et dans le deuxième état (B) un degré de cristallisation qui est grand.

11. Mémoire à semi-conducteurs suivant l'une des revendications 1 à 10,
**caractérisée en ce que**
le support (6) de données contient un chalcogénure ou une pnicogénure.

12. Mémoire à semi-conducteurs suivant l'une des revendications 6 à 11,
**caractérisée en ce que**
le support (6) de données et le matériau (4) sont disposés entre la première électrode (10) et la deuxième électrode (20) et à l'aide des électrodes (10, 20) il peut être envoyé un courant électrique passant dans le support (6) de données.

13. Mémoire à semi-conducteurs suivant l'une des revendications 1 à 12,
**caractérisée en ce que**
la mémoire (1) à semi-conducteurs est une mémoire à changement de phase non volatile.

14. Procédé de production d'une mémoire intégrée à semi-conducteurs qui a les stades suivantes :
- on forme une première électrode (10),
- on dépose une couche (15) isolante du point de vue électrique,
- on dépose un matériau (4) de manière à former une pluralité de parties en un matériau (4), qui ont des dimensions plus petites que des largeurs (18) de structure pouvant être obtenues lithographiquement en mettant fin au dépôt avant que le matériau (4) ait crû en une couche ininterrompue sans lacunes,
- on structure la couche (15) isolante du point de vue électrique en utilisant les parties en le matériau (4) comme masque d'attaque,
- on dépose un support (6) de données qui peut prendre un premier état (A) de petite conductivité électrique et un deuxième état (B) de grande conductivité électrique et qui passe par une transition de phase entre le premier et le deuxième état,
- on forme une deuxième électrode (20) sur ou contre le support (6) de données.

15. Procédé de production d'une mémoire intégrée à semi-conducteurs, qui a les stades suivantes :
- on forme une première électrode (10),
- on dépose un support (6) de données qui peut prendre un premier état (A) de petite conductivité électrique et un deuxième état (B) de grande conductivité électrique et qui passe par une transition de phase entre le premier et le deuxième état,
- on dépose une couche (15) isolante du point de vue électrique,
- on dépose un matériau (4) de façon à former une pluralité de parties en le matériau (4), qui ont des dimensions plus petites que des largeurs (18) de structure pouvant être produites lithographiquement en mettant fin au dépôt avant que le matériau (4) ait crû en une couche ininterrompue sans lacunes,
- on structure la couche (15) isolante du point de vue électrique en utilisant les parties en le matériau (4) comme masque d'attaque, et
- on forme une deuxième électrode (20).

16. Procédé suivant la revendication 14 ou 15,
**caractérisé en ce que**
l'on dépose le support (6) de données tant avant le dépôt du matériau (4) qu'après le dépôt du matériau (4).

17. Procédé suivant l'une des revendications 14 à 16,
**caractérisé en ce que**
l'on met fin au dépôt du matériau (4) avant que des ilots (14) isolés dans l'espace en le matériau (4) aient crû en une couche trouée.

18. Procédé suivant l'une des revendications 14 à 16,
**caractérisé en ce que**
l'on poursuit le dépôt du matériau (4) jusqu'à ce que des ilots (14) isolés dans l'espace en le matériau (4) aient crû en une couche (16) trouée.

19. Procédé suivant l'une des revendications 14 à 16,
**caractérisé en ce que**
lors du dépôt du support (6) de données, on remplit du support (6) de données des parties dans lesquelles la couche (15) isolante du point de vue électrique est attaquée.

20. Procédé suivant l'une des revendications 14 à 19,
**caractérisé en ce que**
par le dépôt du matériau (4) et par le dépôt du support (6) de données, on produit un plan (L) de couche ayant une couche (16) trouée dont les ouvertures sont plus petites qu'une largeur (18) de structure pouvant être dimensionnée lithographiquement.

21. Procédé suivant l'une des revendications 14 à 20,
**caractérisé en ce que**
l'on dépose un support (6) de données qui a dans un premier état (A) un degré de cristallisation qui est petit et dans un deuxième état (B) un degré de cristallisation qui est grand.
